# EUROPEAN PATENT APPLICATION

(11) **EP 3 279 075 A1**
(43) Date of publication of application: **07.02.2018**
(21) Application number: 15887838.9
(22) Date of filing: 14.04.2015
(51) Int. Cl.: B63B 9/00, G06F 17/00, G06F 17/50, B63H 25/42

(54) **TEST SYSTEM FOR DYNAMIC POSITIONING CONTROLLER SYSTEM OF SHIP, HAVING DATA COLLECTION UNIT**

(30) Priority: 01.04.2015 KR 20150046316
(71) Applicant: Panasia Co., Ltd., Busan 618-220 (KR)
(72) Inventor: LEE, Soo-Tae, Busan 608-749 (KR); LEE, Su-Kyu, Busan 612-885 (KR); CHEON, Sang-Gyu, Gimhae-si Gyeongsangnam-do 621-730 (KR); KIM, Joo-Won, Busan 618-706 (KR); LEE, Chang-Ui, Yangsan-si Gyeongsangnam-do 626-795 (KR)
(74) Representative: Klunker IP Patentanwälte PartG mbB
(86) International application number: PCT/KR2015/003717
(87) International publication number: WO 2016/159428

(57) **Abstract**

Disclosed is a test system for a dynamic positioning controller system of a ship, the dynamic positioning controller system generating a control signal containing final destination information of the ship based on a simulated sensor signal, the test system including: an actuator simulator receiving the control signal containing the final destination information of the ship and continuously generating a modeled control signal containing thrust information; a ship simulator receiving the modeled control signal and performing ship motion analysis; a sensor simulator measuring the simulated sensor signal at the ship simulator; and a data collection unit storing a test condition, wherein when the test system repeatedly performs simulation based on the test condition, the data collection unit stores test results and analyzes the stored test results to automatically generate a report, whereby the test system derives highly reliable test results based on the modeled control signal and the simulated sensor signal.

## Description

### Technical Field

The present invention relates to a system for testing and verifying performance of a dynamic positioning controller system of a ship before mounting the dynamic positioning controller system in the ship. More particularly, the present invention relates to a test system for a dynamic positioning controller system of a ship, the test system storing a test condition and a test result and being capable of automatically generating a report on the test based on the test condition and the test result.

### Background Art

A dynamic positioning controller system (DPC system) of a ship is used for station keeping enabling the ship to automatically maintain a fixed position or predefined route at sea without using an anchor or a combination with the anchor of the ship.

The DPC system of the ship is extremely important for safety and mission completion of the ship. For example, when a DPC system of a drillship drilling for oil in deepwater does not work properly, the drillship may move to a wrong position and the connection piping between the drillship and the oil piping connected to deepwater may be broken. Here, oil flowing from the broken connection piping causes many problems such as irrecoverable damage to the marine ecosystem, serious economic losses, and threatening of the safety of works on board the drillship.

Therefore, a ship traveling to a distant ocean may be affected by unexpected failure of the ship (sensor failure or abnormal conditions, etc.) or an external environment (abnormal speed of wave, wave intensity exceeding the expected range, etc.). Thus, extensive tests are required to know how the DPC system operates in expected and unexpected abnormal conditions of the ship.

In the meantime, the DPC system is connected to a number of devices when installed in the actual ship. When the DPC system does not operate normally after being installed in the ship, a number of connection lines are disconnected and connected again to replace the DPC system in the ship. Here, excessive time and effort are required, and a number of lines may be misconnected. Also, when the ship is located in a distant ocean, a new DPC system should be transferred to the ship from land.

Accordingly, even though a DPC system has been completed by the designer, precise testing of the DPC system is essential before mounting the DPC system in the ship. In the meantime, in manufacturing the DPC system, a factory acceptance test (FAT) where the manufacturer inputs a simulated sensor signal to the DPC system and monitors the response of the DPC system may be performed at the factory. The FAT is problematic in that the DPC system cannot be verified in extensive simulation situations since the FAT can identify errors related to only a predicted apparatus from a predicted source.

Recently, the DPC system is connected to a simulator instead of a ship, and is tested through hardware-in-the-loop (HIL) simulation.

In the meantime, due to various reasons during sailing of the ship, replacement/repair, re-programming, etc. of sensors, actuators, cranes, etc. mounted in the ship may change the dynamic positioning controller system. Such change of the DPC system may cause instability of the first authenticated DPC system and may cause risk to the ship. Therefore, it is necessary to periodically confirm whether the DPC system has changed. When the DPC system has changed, new authentication is required to prevent the potential risk that may happen to the ship. Accordingly, in order to identify whether the DPC system operates as intended and as initially authenticated, and whether new errors occur, it is necessary to confirm whether the DPC system has changed by re-testing the DPC system under the same test condition as before.

However, when conditions or limitations of a number of devices installed in the ship are changed and a performance of the DPC system controlling the devices is also changed in consequence of thereof, it is necessary to repeatedly perform testing in order to confirm whether the DPC system has changed. However, conventionally, during HIL testing for the DPC system, complex and numerous test conditions and test results thereof are not stored, and an initial test condition and test result cannot be identified when intending to confirm whether the DPC system has changed. Thus, it is difficult to perform comparative analysis on the test results, and whether the DPC system has changed cannot be confirmed. Accordingly, the ship operates in a state exposed to potential risks.

Therefore, the test results are debated, and when writing a report, the test results cannot be accurately described. Thus, reliability of the test result is low, and utilization of HIL testing for the DPC system is low. Utilization value as authentication data is also low.

Also, when performing HIL testing, the DPC system is required to be individually/physically connected to various simulators such as an actuator simulator, a PMS simulator, a ship simulator, a sensor simulator, etc. Thus, it is temporally ineffective in performing a simulation. A number of connection lines of simulators may be misconnected to the DPC system, and accurate test results cannot be obtained.

Also, since hardware-in-the-loop (HIL) simulation test for the DPC system is performed by using a communication-type interface between the DPC system and the simulator, a simulation for analog values cannot be performed and it is difficult to perform precise HIL testing. For example, in an actual ship, speed or direction of a ship thruster is controlled by outputting analog values, and feedback thereof is in an analog form. An HIL simulation device providing virtual simulation environment performs testing by using the communication-type interface with the DPC system. Thus, the HIL simulation device differs from the control environment in an actual ship, and it is difficult to copy natural noise.

### Disclosure

### Technical Problem

Accordingly, the present invention has been made keeping in mind the above problems occurring in the related art.

An object of the present invention is to provide a test system for a dynamic positioning controller system of a ship, the test system having a data collection unit storing complex and numerous test conditions and test results thereof during HIL testing for the DPC system, whereby whether the DPC system has changed can be confirmed by re-testing the DPC system under the same test condition as before, and thus whether the DPC system is required to be re-authenticated can be confirmed.

Also, an object of the present invention is to provide a test system having the data collection unit for a dynamic positioning controller system of a ship, whereby when conditions or limitations of a number of devices installed in the ship are changed and a performance of the dynamic positioning controller system controlling the devices is also changed in consequence thereof, whether the DPC system operates as intended and as initially authenticated, can be identified and whether new errors occur can be identified.

Also, an object of the present invention is to provide a test system having the data collection unit for a dynamic positioning controller system of a ship, whereby comparative analysis can be performed on a test result of an initial test condition and thus, whether the DPC system has changed can be confirmed and the ship can be prevented from operating in a state exposed to potential risks.

Also, an object of the present invention is to provide a test system having the data collection unit for a dynamic positioning controller system of a ship, whereby a report can be automatically generated based on the stored test result, and thus it is convenient for a test worker to execute a test and a test requester can submit the report as evidence to obtain authentication related to regulations relevant to the DPC system.

Also, an object of the present invention is to provide a test system for a dynamic positioning controller system of a ship, the test system providing one integrated input/output interface, whereby it is convenient to test the dynamic positioning controller system and accurate testing can be performed.

Also, an object of the present invention is to provide a test system for a dynamic positioning controller system of a ship, and the test system provides an analog signal simulator, whereby accurate testing can be performed on a component of the ship requiring analog control.

### Technical Solution

In order to accomplish the above object, the present invention is realized by embodiments having the following configurations.

According to an embodiment of the present invention, there is provided a test system having a data collection unit for testing a dynamic positioning controller system of a ship, the dynamic positioning controller system generating a control signal containing final destination information of the ship based on a simulated sensor signal, the test system including: an actuator simulator receiving the control signal containing the final destination information of the ship and continuously generating a modeled control signal containing thrust information; a ship simulator receiving the modeled control signal and performing ship motion analysis; a sensor simulator measuring the simulated sensor signal at the ship simulator; and a data collection unit storing a test condition, wherein when the test system repeatedly performs simulation based on the test condition, the data collection unit stores test results and analyzes the stored test results to automatically generate a report, whereby the test system derives highly reliable test results based on the modeled control signal and the simulated sensor signal.

According to an embodiment of the present invention, the data collection unit may include a data storage module storing data required in testing the dynamic positioning controller system, the data storage module may include a test condition module storing the test condition and a test result module storing the test results, which are simulated by the test system, of the dynamic positioning controller system in interconnection with the test condition, and the data collection unit may analyze the stored test results to automatically generate the report, whereby the test system derives the highly reliable test results based on the modeled control signal and the simulated sensor signal.

According to an embodiment of the present invention, the data collection unit may include a report generation module automatically generating the report based on the test results of the dynamic positioning controller system, the report generation module may include a report type generation module generating a report type according to a standard corresponding to a ship classification regulation condition required for authenticating a performance of the dynamic positioning controller system, and the data collection unit may analyze the stored test results to automatically generate the report, whereby the test system derives the highly reliable test results based on the modeled control signal and the simulated sensor signal.

According to an embodiment of the present invention, the data collection unit may include a report generation module automatically generating the report based on the test results of the dynamic positioning controller system, the report generation module may include a report type generation module generating a report type according to a standard corresponding to requirements of a ship owner, and the data collection unit may analyze the stored test results to automatically generate the report, whereby the test system derives the highly reliable test results based on the modeled control signal and the simulated sensor signal.

According to an embodiment of the present invention, the report generation module may includes: a report type storage module storing the report generated by the report type generation module; a report type request module requesting the report type according to the standard corresponding to the test condition, etc., from the report type storage module and receiving the report type therefrom; a test result input module including a real-time test result input module storing the test results simulated by the test system in real time and a test result request module requesting the test results stored in the test result module; and a report output module generating the report by writing the test results, which are input to the test result input module, on the report type requested by the report type request module, and the data collection unit may analyze the stored test results to automatically generate the report, whereby the test system derives the highly reliable test results based on the modeled control signal and the simulated sensor signal.

According to an embodiment of the present invention, the data collection unit may include a DP change confirmation module requesting the data stored in the data storage module and performing comparative analysis on the test results of the dynamic positioning controller system, the DP change confirmation module may include a test condition request module requesting the test condition stored in the data storage module and a test result request module requesting the test results corresponding to the test condition, and the data collection unit may analyze the stored test results to automatically generate the report, whereby the test system derives the highly reliable test results based on the modeled control signal and the simulated sensor signal.

According to an embodiment of the present invention, the DP change confirmation module may further include a DP comparison determination module performing the comparative analysis on the requested test results, and the data collection unit may analyze the stored test results to automatically generate the report, whereby the test system derives the highly reliable test results based on the modeled control signal and the simulated sensor signal.

According to an embodiment of the present invention, the test system may further include an integrated input/output interface providing one integrated connection port so that the dynamic positioning controller system is connected to the test system via the one connection port, thus providing convenience in performing testing, wherein the data collection unit may analyze the stored test results to automatically generate the report, whereby the test system derives the highly reliable test results based on the modeled control signal and the simulated sensor signal.

According to an embodiment of the present invention, the test system may further include an analog signal simulator converting communication-type data to analog-type data and transmitting the analog-type data to the dynamic positioning controller system, thus obtaining accurate test results for an analog signal, wherein the connection realized via the one integrated connection port may provide convenience in performing testing, and the data collection unit may analyze the stored test results to automatically generate the report, whereby the test system derives the highly reliable test results based on the modeled control signal and the simulated sensor signal.

According to an embodiment of the present invention, the analog signal simulator may convert analog-type data to communication-type data and transmits the communication-type data to the actuator simulator, thus obtaining the accurate test results for the analog signal, wherein the connection realized via the one integrated connection port may provide convenience in performing testing, and the data collection unit may analyze the stored test results to automatically generate the report, whereby the test system derives the highly reliable test results based on the modeled control signal and the simulated sensor signal.

According to an embodiment of the present invention, the control signal may contain signal information controlling at least one of shaft speed and rotation direction for an actuator, whereby the test system derives the highly reliable test results based on the modeled control signal and the simulated sensor signal.

According to an embodiment of the present invention, the sensor simulator may include at least two of a plurality of GPS sensors detecting a position of the ship by measuring a signal from a satellite and at least two of a plurality of sonar sensors detecting the position of the ship by measuring a signal from a device provided on a seabed, and may transmit a plurality of simulated sensor signals to the dynamic positioning controller system, whereby the test system derives the highly reliable test results based on the modeled control signal and the simulated sensor signal.

### Advantageous Effects

According to the embodiment of the present invention, various effects as follow may be obtained.

The present invention can store complex and numerous test conditions and test results thereof during HIL testing for the DPC system, whereby whether the DPC system has changed can be confirmed by re-testing the DPC system under the same test condition as before, and thus whether the DPC system is required to be re-authenticated can be confirmed.

Also, when conditions or limitations of a number of devices installed in the ship have changed and a performance of the dynamic positioning controller system controlling the devices has also changed in consequence thereof, the present invention can repeatedly test the DPC system based on whether the DPC system operates as intended and as initially authenticated, whether new errors occur, under the same test condition. Accordingly, a performance of the DPC system can be exhaustively tested according to specifications of the DPC system.

Also, the present invention can perform comparative analysis on a test result of an initial test condition and thus, whether the DPC system has changed can be confirmed and the ship can be prevented from operating in a state exposed to potential risks.

Also, the present invention can automatically store the test condition and the test result thereof, and can automatically generate the report based on the stored data, whereby a debate on the test result can be reduced and reliability thereon can be increased.

Also, the present invention can automatically generate a report based on the stored test result according to ship regulation condition and/or requirements of a ship owner, whereby it is convenient for a test worker to execute a test and authentication related to regulations relevant to the DPC system can be obtained by using a highly reliable report as evidence.

The present invention provides one integrated input/output interface for HIL testing of the DPC system such that the present invention can reduce the inconvenience of individually/physically connecting a number of simulators and can reduce a possibility of misconnecting a number of connection lines of the simulators to the DPC system, thereby obtaining an accurate test result.

Also, the present invention provides an analog signal simulator for HIL testing of the DPC system to enhance the ability of simulating analog noise, whereby a simulation environment similar to an actual ship environment can be provided and accuracy of an analog calculation for the DPC system can be tested.

Also, before mounting the DPC system in the ship, the present invention can repeatedly test the DPC system by being connected to the simulator instead of the ship, through hardware-in-the-loop (HIL) simulation test. An algorithm of the DPC system can be modified by solving problems based on the test result. Accordingly, the present invention can provide the DPC system capable of handling various situations about internal and external environments of the ship. Also, it is possible to effectively prevent problems such as irrecoverable economic losses caused by failure of the DPC system in the actual ship.

Also, before mounting the DPC system in the ship, the present invention tests and verifies a performance and failure response ability of the DPC system such that hidden errors, parameters, and design errors can be detected, whereby the verified DPC system can be perfectly integrated with other ship systems.

### Description of Drawings

FIG. 1 is a configuration diagram illustrating a test system for a dynamic positioning controller system.
FIG. 2 is a configuration diagram illustrating a test system including a data collection unit, for a dynamic positioning controller system.
FIG. 3 is a block diagram illustrating in detail a data storage module of the data collection unit of FIG. 2.
FIG. 4 is a block diagram illustrating in detail a report generation module of the data collection unit of FIG. 2.
FIG. 5 is a block diagram illustrating in detail a DP change confirmation module of the data collection unit of FIG. 2.
FIG. 6 is a configuration diagram illustrating a test system including a data collection unit and an integrated input/output interface, for testing a dynamic positioning controller system.
FIG. 7 is a configuration diagram illustrating a test system including a data collection unit, an integrated input/output interface, and an analog signal simulator, for testing a dynamic positioning controller system.

### Best Mode

Hereinafter, an embodiment of the present invention will be described in detail with reference to the accompanying drawings. It should be understood that the embodiment of the present invention may be changed according to a variety of embodiments and the scope and spirit of the present invention are not limited to the embodiment described hereinbelow. The embodiment of the present invention is provided for allowing those skilled in the art to more clearly comprehend the present invention. Therefore, it should be understood that the shape and size of the elements shown in the drawings may be exaggeratedly drawn to provide an easily understood description of the structure of the present invention.

A test system including a data collection unit, for a dynamic positioning controller system of a ship of the present invention will be described in detail with reference to the drawings.

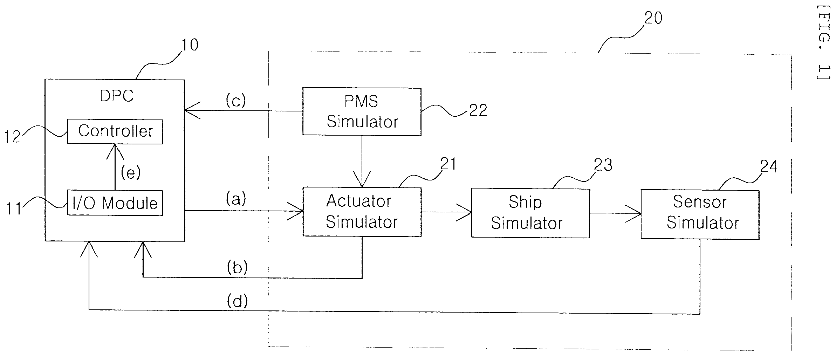

Referring to FIG. 1, a test system for a dynamic positioning controller system of a ship according to an embodiment of the present invention includes a dynamic positioning controller system 10 and a test system 20. The dynamic positioning controller system 10 may include an analog signal I/O module 11 and a controller 12, and may generate a control signal containing final destination information of the ship according to an algorithm.

The analog signal I/O module 11 may includes hundreds to thousands of I/Os to transmit or receive analog-type signals to or from the test system 20 and to be connected to numerous simulation devices included in the test system 20. In the meantime, the analog signal I/O module 11 may receive analog data such as analog sensor data and signal, etc. from the test system 20 and may transmit the received analog data to the controller 12.

The controller 12 may control overall operation of the dynamic positioning controller system 10, and may generate a control signal by receiving a simulated sensor signal from the analog signal I/O module 11. The control signal may contain final destination information of the ship. A connection line (e) shown in FIG. 1 indicates that the controller 12 receives data from the analog signal I/O module 11 by a digital communication method.

In the present invention, the analog signal I/O module 11 may receive an analog signal from the test system 20 and may transmit the received data to the controller 12 by a digital communication method. As another embodiment, the analog signal I/O module 11 may receive the control signal from the controller 12 by a digital communication method and may convert the received data to an analog-type control signal to transmit the analog-type control signal to the test system 20.

In the meantime, in the present invention, the dynamic positioning controller system 10 corresponds to a dynamic positioning controller system (DPC system) of a ship that is a system completed by a designer. When the DPC system passes verification of the test system 20, the DPC system is mounted in an actual ship and controls a dynamic position of the actual ship.

The dynamic positioning controller system 10 includes an algorithm set by a user, and generates a control signal for a simulation situation, provided by the test system 20, according to the algorithm by being connected to the test system 20 rather than an actual ship, whereby a performance of the DPC system is verified. In order to perform verification of the present invention, the test system 20 transmits a virtual simulated sensor signal to the dynamic positioning controller system 10, and the dynamic positioning controller system 10 generates an initial control signal based on the received simulated sensor signal.

The control signal may contain signal information that is information on a final target position of the actual ship and controls at least one of shaft speed and rotation direction corresponding to force and direction of moving the actuator.

According to the present invention, a control signal, generated by the controller 12, containing final destination information of the ship is input to the test system 20 providing a virtual ship environment to perform a simulation, and the result thereof feeds back to the dynamic positioning controller system 10.

The controller 12 receives the simulated sensor signal which is fed back, and generates a control signal containing final destination information of the ship. Feedback is repeated, and thus the control signal is repeatedly generated in order. According to this feedback process, whether or not the dynamic positioning controller system 10 generates a normal control signal under given conditions may be verified by visually identifying that a ship model displayed on a monitor (not shown) moves in response to the control signal.

The test system 20 may include an actuator simulator 21, a PMS simulator 22, a ship simulator 23, and a sensor simulator 24, and may verify a performance of the dynamic positioning controller system 10 by generating a simulation situation according to a test condition. In the present invention, the test system 20 may be realized by a hardware-in the loop (HIL) simulation test being connected to simulators instead of a ship.

The dynamic positioning controller system 10 may be connected to the actuator simulator 21 via connection lines (a) and (b), may be connected to the PMS simulator 22 via a connection line (c), and may be connected to the sensor simulator 24 via a connection line (d). The test system 20 performs a simulation for testing the dynamic positioning controller system 10.

In FIG. 1, simply, four lines are designated as the connection lines (a) to (d), but in order to actually perform HIL testing on the dynamic positioning controller system 10, a number of lines included in the connection lines (a) to (d) are individually connected to an internal analog signal I/O module 11 of the dynamic positioning controller system 10. Therefore, the analog signal I/O module 11 may have as much I/Os as the number of connection lines corresponding to be connected to a number of lines included in the connection lines (a) to (d).

The actuator simulator 21 is realized by parameters similar to those of an actuator of an actual ship, and continuously transmits control signals to the ship simulator 23 in the similar manner of the actuator provided in the actual ship. A control signal generated by the actuator simulator 21 is defined as a modeled control signal containing thrust information, and the thrust information means information on force and direction provided from the actuator.

For example, when a control signal containing information that a ship is currently positioned at Latitude: N 30°/ Longitude: E 30° and a target position of the ship is Latitude: N 50°/ Longitude: E 50°, is transmitted to the actuator simulator 21, the actuator simulator 21 may transmit information on force and direction generated by the actuator per unit time (or one minute) to the ship simulator 23.

The actuator simulator 21 continuously transmits information on force and direction generated by the actuator to the ship simulator 23 until the ship reaches the final target position, and transmits related information to the analog signal I/O module 11. Also, the actuator simulator request required power from the PMS simulator 22.

The PMS simulator 22 is a power management system (PMS) which is a power system providing required power to a ship. When the PMS simulator 22 receives a power request signal from the actuator simulator 21, the PMS simulator transmits a value corresponding to the request power to the actuator simulator 21 and transmits related information to the analog signal I/O module 11.

The ship simulator 23 may perform ship motion analysis by being modeled similar to an actual ship. For example, when the information on force and direction that is generated by passing an actual actuator target control value, which is received from the dynamic positioning controller system 10, through the actuator simulator 21 in the similar manner of response of the actual actuator is transmitted to the ship simulator 23, the ship simulator 23 may perform ship motion analysis in response to the relevant control signal.

According to the result of motion analysis of the ship simulator 23, the sensor simulator 24 performs a simulation where the position and speed of the ship simulator 23 is simultaneously or selectively measured, and transmits the simulated sensor signal to the analog signal I/O module 11.

The sensor simulator 24 may include virtual sensors such as a GPS sensor (not shown) detecting a position of the ship by measuring a signal from a satellite, a sonar sensor (not shown) detecting a position of the ship by measuring a signal from a device installed at a seabed, a wind sensor (not shown) measuring wind in an area where the ship is positioned, etc. A plurality of each of the virtual sensors may be realized.

Therefore, when the ship simulator 23 performs motion analysis in response to the control signal received from the actuator simulator 21, the plurality of virtual sensors perform simulations where simulated sensor signals are generated by measuring data about the position and direction, etc. of the motion analyzed ship in real time or in every cycle, and by converting the data into latitude/longitude and orientation information, etc. The sensor simulator 24 transmits the simulated sensor signals to the analog signal I/O module 11.

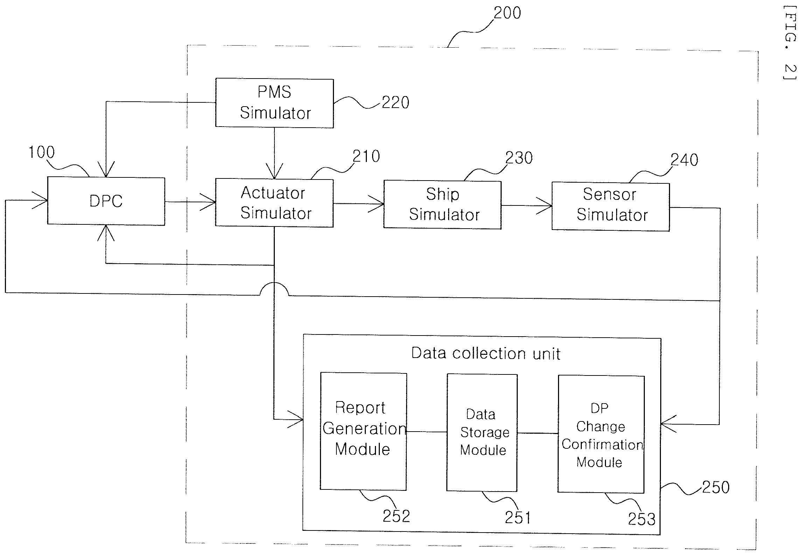

Referring to FIGS. 2 to 5, a test system 200 according to an embodiment of the present invention may include an actuator simulator 210, a PMS simulator 220, a ship simulator 230, a sensor simulator 240, and a data collection unit 250. The test system stores a test result of the dynamic positioning controller system 100 and automatically generates a report. Functions of other components are the same as described above, and hereinafter, the data collection unit 250 will be described in detail.

The data collection unit 250 includes a data storage module 251, a report generation module 252, and a DP change confirmation module 253, stores the test result of the dynamic positioning controller system 100, and automatically generates a report.

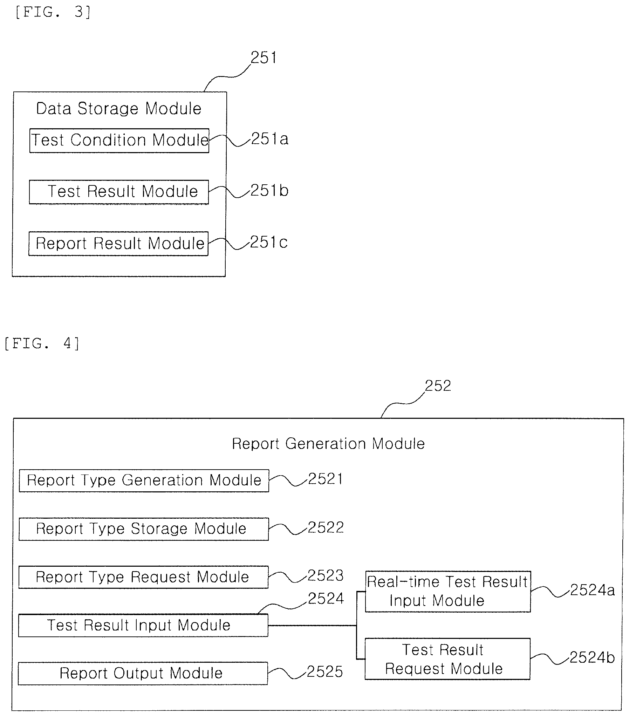

Referring to FIG. 3, the data storage module 251 includes a test condition module 251a, a test result module 251b, and a report result module 251c, and stores data required in performing a simulation on the dynamic positioning controller system 100.

The test condition module 251a stores a test condition for testing a performance of the dynamic positioning controller system 100. The test condition includes a condition for testing whether a performance defined by relevant regulations of the dynamic positioning controller system 100 is satisfied, a condition for testing whether a ship owner requested performance is satisfied, etc.

In the meantime, due to various reasons during sailing of the ship, replacement/repair, re-programming, etc. of sensors, actuators, cranes, etc. mounted in the ship may change the dynamic positioning controller system 100. Also, it is difficult to perfectly integrate such changed dynamic positioning controller system 100 with other ship systems, and thus risk to the ship may occur.

Therefore, it is necessary to periodically confirm whether the dynamic positioning controller system 100 has changed, and when it has changed, new authentication is necessary to prevent the potential risk that may happen to the ship. Accordingly, in order to identify whether the dynamic positioning controller system 100 operates as intended and as initially authenticated, and whether new errors occur, it is necessary to confirm whether the dynamic positioning controller system 100 has changed by re-testing the dynamic positioning controller system 100 under the same test condition as before.

When conditions or limitations of a number of devices installed in the ship are changed and a performance of the dynamic positioning controller system 100 controlling the devices is also changed in consequence thereof, the test condition module 251a of the present invention may store complex and numerous test conditions required for HIL testing in order to confirm whether the dynamic positioning controller system 100 has changed.

That is, the test condition module 251a provides test conditions for events (simulation situations) related to normal or abnormal situations that the ship may encounter, to the test system 200. According to the embodiment of the present invention, events may be provided to the actuator simulator 210 and the sensor simulator 240 simultaneously or selectively in order to test the dynamic positioning controller system 100 in various simulation situations.

The test result module 251b stores the test result that is simulated by the test system 200. The test result is stored in the test result module 251b in interconnection with the test condition. Test results of components of the ship such as the actuator simulator 210, the sensor simulator 240, etc. may be separately stored.

In the meantime, when condition or limitations of a number of devices installed in the ship are changed and it is necessary to repeatedly test the dynamic positioning controller system 100 to confirm whether the dynamic positioning controller system 100 controlling the devices has changed, the test result module 251b may store test results corresponding to numerous test conditions.

Accordingly, the test result module 251b may provide test results corresponding to numerous test conditions to the report generation module 252 and the DP change confirmation module 253, and thus it is easy to perform comparative analysis on the test results and easy to confirm whether the dynamic positioning controller system 100 has changed, whereby the ship can be prevented from operating in a state exposed to potential risks.

The report result module 251c may store the report generated by the report generation module 252 with the test date. Therefore, reports, stored in the report result module 251c, of the test results corresponding to various conditions may be easily found by test date, and may be utilized as comparative analysis data.

Referring to FIG. 4, the report generation module 252 may include a report type generation module 2521, a report type storage module 2522, a report type request module 2523, a test result input module 2524, and a report output module 2525, and may automatically generate a report based on the test result of the dynamic positioning controller system 100.

The report type generation module 2521 generates a report type according to a standard corresponding to a ship classification regulation condition required for authenticating a performance of the dynamic positioning controller system 100 or according to a standard corresponding to requirements of a ship owner for the dynamic positioning controller system 100. Without being limited thereto, the report type generation module 2521 may generate report types according to various standards.

The report type storage module 2522 stores the report generated by the report type generation module 2521, and transmits the report to the report type request module 2523 when requesting from the report type request module 2523.

The report type request module 2523 requests the report type according to the standard corresponding to the test condition, etc., from the report type storage module 2522, and receives the report type therefrom.

The test result input module 2524 includes a real-time test result input module 2524a and a test result request module 2524b, and inputs test results corresponding to test conditions, etc. required in writing reports.

The real-time test result input module 2524a may store the test result simulated by the test system 200. In the meantime, the test result request module 2524b may request the test result simulated by the test system 200 and stored in the test result module 251b.

The report output module 2525 generates a report by writing the test result that is input to the test result input module 2524 on the report type requested by the report type request module 2523.

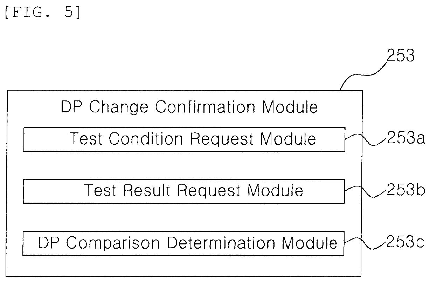

Referring to FIG. 5, the DP change confirmation module 253 includes a test condition request module 253a, a test result request module 253b, and a DP comparison determination module 253c, and performs comparative analysis on test results for a plurality of test conditions.

Due to replacement/repair, etc. of devices such as sensors and actuators mounted in the ship, when the dynamic positioning controller system 100 controlling the devices is re-programmed, in order to identify whether the changes operate as intended and whether new errors occur, the test system 200 may re-test the dynamic positioning controller system 100 under the same test condition as before. The test condition and corresponding test result are respectively stored in the test condition module 251a and the test result module 251b.

The test condition request module 253a requests the condition of simulation situation related to normal or abnormal situations that the ship may encounter, from the test condition module 251a.

The test result request module 253b requests a plurality of test results in consequence of the test conditions, from the test result module 251b. In the present invention, it is not limited to request a plurality of test results in consequence of the same test condition of the dynamic positioning controller system 100, and it also requests a plurality of test results in consequence of different test conditions.

In order to analyze the influence of individual components such as the actuator simulator 210, the sensor simulator 240 on the dynamic positioning controller system 100, the test result request module 253b may separately request the test results of the components. Here, the actuator simulator 210 and the sensor simulator 240 may respectively provide simulation situations corresponding to the actuator and the sensor mounted in the actual ship, to the dynamic positioning controller system 100.

When conditions or limitations of a number of devices installed in the ship are changed and a performance of the dynamic positioning controller system 100 controlling the devices is also changed in consequence thereof, the DP comparison determination module 253c may compare an initial test result with a test result of the changed dynamic positioning controller system 100 under the same test condition. Accordingly, when the dynamic positioning controller system 100 is re-programmed, whether the changes operate as intended and whether new errors occur may be identified.

Also, the DP comparison determination module 253c performs comparative analysis on the test result simulated by the test system 200 and other various test results according to specifications of the dynamic positioning controller system 100, thereby analyzing the influence of the changed test condition on the dynamic positioning controller system 100.

When the DP comparison determination module 253c performs comparative analysis on the test result and determines that the dynamic positioning controller system 100 has changed, the changed dynamic positioning controller system 100 requires new authentication.

Accordingly, the DP comparison determination module 253c may determine whether the dynamic positioning controller system 100 is a re-authentication target before obtaining new authentication. The changed dynamic positioning controller system 100 is compared with a previous dynamic positioning controller system 100. When there is no difference in performance, the changed dynamic positioning controller system 100 may be used by being mounted in the ship without re-authentication. When there is a difference in performance and the difference exceeds an allowable range and thus, the DPC system is determined as a re-authentication target, the DP comparison determination module 253c may determine that the changed dynamic positioning controller system 100 is a re-authentication target.

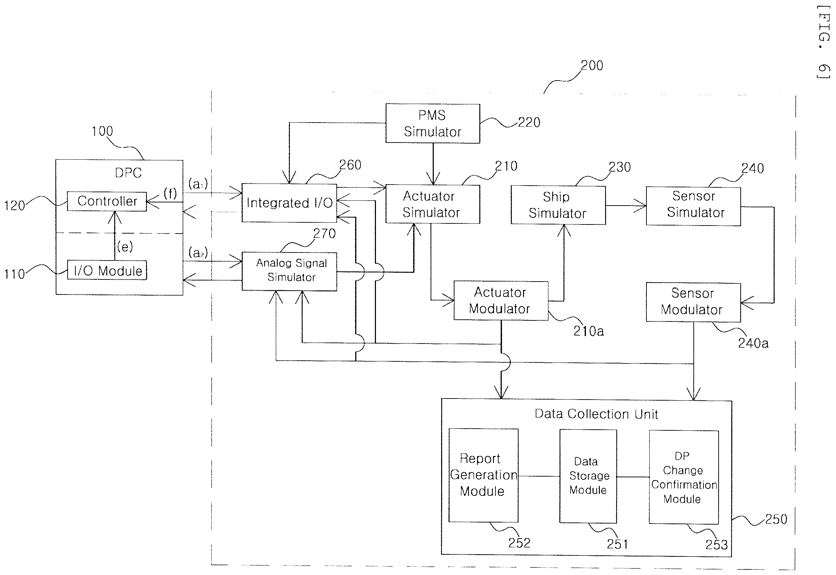

Referring to FIG. 6, a test system including a data collection unit, for a dynamic positioning controller system of a ship according to an embodiment of the present invention includes a dynamic positioning controller system 100 and a test system 200.

The test system 200 includes an actuator simulator 210, a PMS simulator 220, a ship simulator 230, a sensor simulator 240, a data collection unit 250, and an integrated input/output interface 260, stores the test result of the dynamic positioning controller system 100, and automatically generates the report. Functions of other components are the same as described above, and hereinafter, the integrated input/output interface 260 will be described in detail.

As described above, referring to FIG. 1, when connecting the dynamic positioning controller system 10 to the test system 20 in order to test the dynamic positioning controller system 10, the analog signal I/O module 11 is required to be connected to the numerous simulation devices included in the test system 20 via hundreds to thousands of I/Os. However, in this case, physically connecting/disconnecting numerous connection lines (a) to (d) to/from the analog signal I/O module 11 via hundreds to thousands of I/Os is temporally/spatially ineffective and misconnection may occur. Thus, it is difficult to precisely verify the dynamic positioning controller system 10.

Therefore, according to another embodiment of the present invention, numerous connection lines (a) to (d) of FIG. 1 are disconnected in software, and one integrated input/output interface 260 is provided.

Comparing FIG. 2 with FIG. 6, the integrated input/output interface 260 transmits a digital communication-type signal via a connection line (a1), the controller 12 may directly receives the digital communication-type signal via an inner connection line (f). Therefore, according to the embodiment of the present invention, the integrated input/output interface 260 may directly transmit signal information to the controller 120 without the analog signal I/O module 110. In this case, the analog signal I/O module 110 may be maintained in software disconnection state to the controller 120.

In the meantime, the integrated input/output interface 260 may provide a single input/output interface of the test system 200, and may be realized by Ethernet. The network type of Ethernet is a bus type, and access scheme CSMA/CD may be adopted. That is, in Ethernet, one physical transmission medium is shared by a plurality of communication stations. Whether a network to which data to be transmitted is used is checked, and then when the network is empty, the data is transmitted. In Ethernet, when the network is being used, after waiting for a predetermined time, the network is checked again to determine whether to transmit data. In the present invention, the integrated input/output interface 260 is realized by Ethernet, whereby a single input/output interface can be provided physically on in software.

According to still another embodiment of the present invention, the test system 200 may be realized as one PC by realizing the actuator simulator 210, the PMS simulator 220, the ship simulator 230, the sensor simulator 240, and the data collection unit 250 in software.

Therefore, when the test system 200 is realized as a PC, the integrated input/output interface 260 may serves as a single connection interface connecting the dynamic positioning controller system 100 to the test system 200.

When the test system 200 is realized by providing the actuator simulator 210, the PMS simulator 220, the ship simulator 230, the sensor simulator 240, and the data collection unit 250 as individual devices, the integrated input/output interface 260 is realized as a multi-input single-output device and serves as a single connection port connecting the dynamic positioning controller system 100 to the test system 200.

Accordingly, in the process of performing a simulation on the dynamic positioning controller system 100 by individually or simultaneously changing values for the actuator simulator 210 and the sensor simulator 240, the test system 200 tests the dynamic positioning controller system 100 by feeding back the modeled control signal and the simulated sensor signal to the dynamic positioning controller system 100 via the integrated input/output interface 260. Also, the test condition and the test result are stored in the data collection unit 250, comparative analysis is performed on the test result, and a report is automatically generated.

In other words, the present invention provides a software single input/output interface by using the integrated input/output interface 260. Thus, when connecting the dynamic positioning controller system 100 to the test system 200 to test the dynamic positioning controller system 100, the analog signal I/O module 110 is disconnected from the controller 120 in software, and the integrated input/output interface 260 may directly transmit or receive data to or from the controller 120 via the connection line (f) in a digital communication form. Accordingly, the present invention can reduce the inconvenience of individually/physically disconnecting/connecting the connection line of the simulator from/to the analog signal I/O module 110 and can reduce a possibility of misconnecting numerous connection lines of the simulator to the analog signal I/O module 110, whereby precise test result can be obtained.

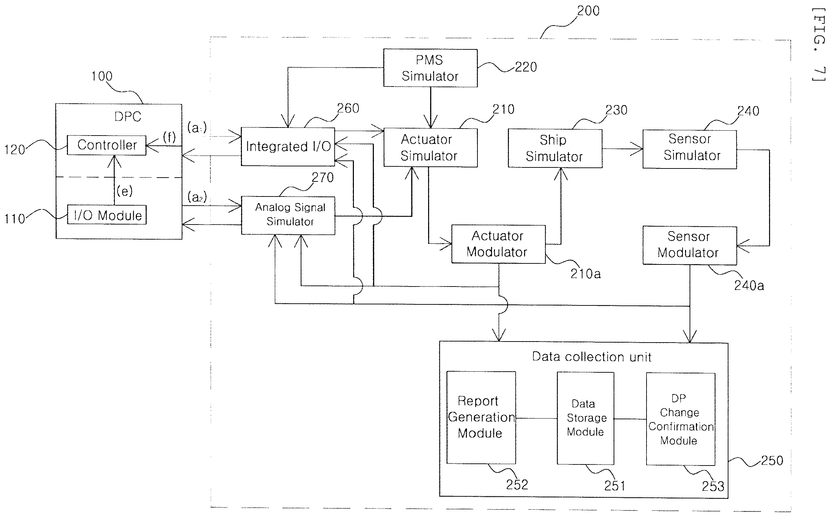

Referring to FIG. 7, according to still another embodiment of the present invention, the test system 200 includes the actuator simulator 210, the PMS simulator 220, the ship simulator 230, the sensor simulator 240, the data collection unit 250, the integrated input/output interface 260, and an analog signal simulator 270, stores a test result of the dynamic positioning controller system 100, and automatically generates a report. Functions of other components are the same as described above, and hereinafter, the analog signal simulator 270 will be described in detail.

According to the embodiment of the present invention, the dynamic positioning controller system 100 and the test system 200 use the integrated input/output interface 260, whereby HIL testing can be performed by using an inter-communication type (digital-type) interface. However, in an actual ship, the dynamic positioning controller system 100 generates speed and direction control signal for the actuator in an analog form, and receives feedback in an analog form in response to the control signal.

The present invention includes the analog signal simulator 270 in order to provide a simulation similar to the actual ship situation for the control signal when performing HIL testing on the dynamic positioning controller system 100 by using the integrated input/output interface 260. Accordingly, like the internal analog signal I/O module 110 of the dynamic positioning controller system 100, when an analog device is required to be verified, all or a part of the interface is used as the analog signal simulator 270 to perform a simulation.

Fundamentally, a simulation is realized by using the integrated input/output interface 260 as a single input/output interface such that simulation process is easy. When analog verification is required, the analog signal simulator 270 can be used only where necessary. Also, in order to make the situation similar to the actual ship, the analog signal simulator 270 may generate natural noise and transmit the noise with the simulation result to the analog signal I/O module 110.

The analog signal simulator 270 receives an analog-type control signal from the analog signal I/O module 110, converts the received control signal into a communication-type control signal, and transmits the communication-type control signal to the actuator simulator 210. Next, when a simulation for the communication-type control signal is performed by the test system 200, the analog signal simulator 270 converts the result thereof into an analog form, and transmits the result to the analog signal I/O module 110.

Accordingly, fundamentally, the integrated input/output interface 260 may directly transmit or receive digital communication-type data to or from the controller 120 via the connection line (f). Additionally, for signals that require analog testing, the analog signal simulator 270 may communicate with the analog signal I/O module 110 by using an analog-type signal. Here, the analog signal input to the analog signal I/O module 110 is converted into a digital communication-type signal, and the digital communication-type signal is transmitted to the controller 120.

Accordingly, when the test system 200 individually or simultaneously changes values for the actuator simulator 210 and the sensor simulator 240 and performs a simulation on the dynamic positioning controller system 100, the analog signal simulator 270 converts the control signal into a communication-type control signal and transmits the communication-type control signal to the actuator simulator 210, and converts a communication-type simulation result into an analog-type simulation result and feeds back the analog-type simulation result to the dynamic positioning controller system 100, whereby it is possible to perform precise testing for analog values. Here, in order to perform communication for feeding back the modeled control signal containing thrust information and the simulated sensor signal to the dynamic positioning controller system 100, the analog signal simulator 270 may convert the modeled control signal and the simulated sensor signal from the analog form into the communication form.

While the embodiments of the invention have been described above, the embodiments are only examples of the present invention. Also, the disclosure shows and describes only the preferred embodiments of the invention but, as mentioned above, it is to be understood that the invention is capable of use in various other combinations, modifications, and environments. That is, it should be understood that numerous other modifications and embodiments can be devised by those skilled in the art that fall within the spirit and scope of the principles of this disclosure. The embodiments disclosed herein, therefore, are not to be taken in a sense of limiting the technical concept of the present invention but as an explanation thereof, and the range of the technical concept is not limited to these embodiments. The scope of the present invention should be construed by the appended claims, along with the full range of equivalents to which such claims are entitled.

## Claims

1. A test system having a data collection unit for testing a dynamic positioning controller system of a ship, the dynamic positioning controller system generating a control signal containing final destination information of the ship based on a simulated sensor signal,
the test system comprising:
an actuator simulator receiving the control signal containing the final destination information of the ship and continuously generating a modeled control signal containing thrust information;
a ship simulator receiving the modeled control signal and performing ship motion analysis;
a sensor simulator measuring the simulated sensor signal at the ship simulator; and
a data collection unit storing a test condition,
wherein when the test system repeatedly performs simulation based on the test condition, the data collection unit stores test results and analyzes the stored test results to automatically generate a report, whereby the test system derives highly reliable test results based on the modeled control signal and the simulated sensor signal.

2. The test system of claim 1, wherein the data collection unit includes a data storage module storing data required in testing the dynamic positioning controller system,
the data storage module includes a test condition module storing the test condition and a test result module storing the test results, which are simulated by the test system, of the dynamic positioning controller system in interconnection with the test condition, and
the data collection unit analyzes the stored test results to automatically generate the report, whereby the test system derives the highly reliable test results based on the modeled control signal and the simulated sensor signal.

3. The test system of claim 2, wherein the data collection unit includes a report generation module automatically generating the report based on the test results of the dynamic positioning controller system,
the report generation module includes a report type generation module generating a report type according to a standard corresponding to a ship classification regulation condition required for authenticating a performance of the dynamic positioning controller system, and
the data collection unit analyzes the stored test results to automatically generate the report, whereby the test system derives the highly reliable test results based on the modeled control signal and the simulated sensor signal.

4. The test system of claim 2, wherein the data collection unit includes a report generation module automatically generating the report based on the test results of the dynamic positioning controller system,
the report generation module includes a report type generation module generating a report type according to a standard corresponding to requirements of a ship owner, and
the data collection unit analyzes the stored test results to automatically generate the report, whereby the test system derives the highly reliable test results based on the modeled control signal and the simulated sensor signal.

5. The test system of claim 3 or 4, wherein the report generation module includes:
a report type storage module storing the report generated by the report type generation module;
a report type request module requesting the report type according to the standard corresponding to the test condition, etc., from the report type storage module and receiving the report type therefrom;
a test result input module including a real-time test result input module storing the test results simulated by the test system in real time and a test result request module requesting the test results stored in the test result module; and
a report output module generating the report by writing the test results, which are input to the test result input module, on the report type requested by the report type request module, and
the data collection unit analyzes the stored test results to automatically generate the report, whereby the test system derives the highly reliable test results based on the modeled control signal and the simulated sensor signal.

6. The test system of claim 5, wherein the data collection unit includes a DP change confirmation module requesting the data stored in the data storage module and performing comparative analysis on the test results of the dynamic positioning controller system,
the DP change confirmation module includes a test condition request module requesting the test condition stored in the data storage module and a test result request module requesting the test results corresponding to the test condition, and
the data collection unit analyzes the stored test results to automatically generate the report, whereby the test system derives the highly reliable test results based on the modeled control signal and the simulated sensor signal.

7. The test system of claim 6, wherein the DP change confirmation module further includes a DP comparison determination module performing the comparative analysis on the requested test results, and
the data collection unit analyzes the stored test results to automatically generate the report, whereby the test system derives the highly reliable test results based on the modeled control signal and the simulated sensor signal.

8. The test system of claim 1, further comprising:
an integrated input/output interface providing one integrated connection port so that the dynamic positioning controller system is connected to the test system via the one connection port, thus providing convenience in performing testing,
wherein the data collection unit analyzes the stored test results to automatically generate the report, whereby the test system derives the highly reliable test results based on the modeled control signal and the simulated sensor signal.

9. The test system of claim 8, further comprising:
an analog signal simulator converting communication-type data to analog-type data and transmitting the analog-type data to the dynamic positioning controller system, thus obtaining accurate test results for an analog signal,
wherein the connection realized via the one integrated connection port provides convenience in performing testing, and
the data collection unit analyzes the stored test results to automatically generate the report, whereby the test system derives the highly reliable test results based on the modeled control signal and the simulated sensor signal.

10. The test system of claim 9, wherein the analog signal simulator converts analog-type data to communication-type data and transmits the communication-type data to the actuator simulator, thus obtaining the accurate test results for the analog signal,
wherein the connection realized via the one integrated connection port provides convenience in performing testing, and
the data collection unit analyzes the stored test results to automatically generate the report, whereby the test system derives the highly reliable test results based on the modeled control signal and the simulated sensor signal.

11. The test system of claim 1, wherein the control signal contains signal information controlling at least one of shaft speed and rotation direction for an actuator, whereby the test system derives the highly reliable test results based on the modeled control signal and the simulated sensor signal.

12. The test system of claim 1, wherein the sensor simulator includes at least two of a plurality of GPS sensors detecting a position of the ship by measuring a signal from a satellite and at least two of a plurality of sonar sensors detecting the position of the ship by measuring a signal from a device provided on a seabed, and transmits a plurality of simulated sensor signals to the dynamic positioning controller system, whereby the test system derives the highly reliable test results based on the modeled control signal and the simulated sensor signal.

## Amended claims

### Amended claims under Art. 19.1 PCT

1. (amended) A test system for testing a dynamic positioning controller system generating a control signal containing final destination information of a ship based on a simulated sensor signal, the test system comprising:
an actuator simulator receiving the control signal containing the final destination information of the ship and continuously generating a modeled control signal containing thrust information;
a ship simulator modeling an actual ship by receiving the modeled control signal to perform ship motion analysis;
a sensor simulator including a plurality of virtual sensors and measuring the simulated sensor signal when the ship simulator performs the ship motion analysis; and
a data collection unit storing a test condition,
wherein when the test system repeatedly performs simulation based on the test condition, the data collection unit stores test results, and analyzes the stored test results to automatically generate a report, whereby the test system derives highly reliable test results based on the modeled control signal and the simulated sensor signal.

2. (amended) The test system of claim 1, wherein the data collection unit includes:
a data storage module storing data required in testing the dynamic positioning controller system;
a report generation module automatically generating the report based on the test results of the dynamic positioning controller system; and
a DP change confirmation module requesting the data stored in the data storage module and performing comparative analysis on the test results of the dynamic positioning controller system,
whereby the test system derives the highly reliable test results based on the modeled control signal and the simulated sensor signal.

3. (amended) The test system of claim 2, wherein the data storage module includes a test condition module storing the test condition and a test result module storing the test results, which are simulated by the test system, of the dynamic positioning controller system in interconnection with the test condition, and
the data collection unit analyzes the stored test results to automatically generate the report, whereby the test system derives the highly reliable test results based on the modeled control signal and the simulated sensor signal.

4. (amended) The test system of claim 3, wherein the report generation module includes a report type generation module generating a report type according to a standard corresponding to a ship classification regulation condition required for authenticating a performance of the dynamic positioning controller system, and
the data collection unit analyzes the stored test results to automatically generate the report, whereby the test system derives the highly reliable test results based on the modeled control signal and the simulated sensor signal.

5. (amended) The test system of claim 3, wherein the report generation module includes a report type generation module generating a report type according to a standard corresponding to requirements of a ship owner, and
the data collection unit analyzes the stored test results to automatically generate the report, whereby the test system derives the highly reliable test results based on the modeled control signal and the simulated sensor signal.

6. (amended) The test system of claim 4 or 5, wherein the report generation module includes:
a report type storage module storing the report generated by the report type generation module;
a report type request module requesting the report type according to the standard corresponding to the test condition, etc., from the report type storage module and receiving the report type therefrom;
a test result input module including a real-time test result input module storing the test results simulated by the test system in real time and a test result request module requesting the test results stored in the test result module; and
a report output module generating the report by writing the test results, which are input to the test result input module, on the report type requested by the report type request module, and
the data collection unit analyzes the stored test results to automatically generate the report, whereby the test system derives the highly reliable test results based on the modeled control signal and the simulated sensor signal.

7. (amended) The test system of claim 6, wherein the DP change confirmation module includes a test condition request module requesting the test condition stored in the data storage module and a test result request module requesting the test results corresponding to the test condition, and
the data collection unit analyzes the stored test results to automatically generate the report, whereby the test system derives the highly reliable test results based on the modeled control signal and the simulated sensor signal.

8. (amended) The test system of claim 7, wherein the DP change confirmation module further includes a DP comparison determination module performing the comparative analysis on the requested test results, and
the data collection unit analyzes the stored test results to automatically generate the report, whereby the test system derives the highly reliable test results based on the modeled control signal and the simulated sensor signal.

9. (amended) The test system of claim 1, further comprising:
an integrated input/output interface providing one integrated connection port so that the dynamic positioning controller system is connected to the test system via the one integrated connection port, thus providing convenience in performing testing,
wherein the data collection unit analyzes the stored test results to automatically generate the report, whereby the test system derives the highly reliable test results based on the modeled control signal and the simulated sensor signal.

10. (amended) The test system of claim 9, further comprising:
an analog signal simulator converting communication-type data to analog-type data and transmitting the analog-type data to the dynamic positioning controller system, thus obtaining accurate test results for an analog signal,
wherein the connection realized via the one integrated connection port provides convenience in performing testing, and
the data collection unit analyzes the stored test results to automatically generate the report, whereby the test system derives the highly reliable test results based on the modeled control signal and the simulated sensor signal.

11. (amended) The test system of claim 10, wherein the analog signal simulator converts analog-type data to communication-type data and transmits the communication-type data to the actuator simulator, thus obtaining the accurate test results for the analog signal,
the connection realized via the one integrated connection port provides convenience in performing testing, and
the data collection unit analyzes the stored test results to automatically generate the report, whereby the test system derives the highly reliable test results based on the modeled control signal and the simulated sensor signal.

12. (amended) The test system of claim 1, wherein the control signal contains signal information controlling at least one of shaft speed and rotation direction for an actuator, whereby the test system derives the highly reliable test results based on the modeled control signal and the simulated sensor signal.

13. (added) The test system of claim 1, wherein the sensor simulator includes at least two of a plurality of GPS sensors detecting a position of the ship by measuring a signal from a satellite and at least two of a plurality of sonar sensors detecting the position of the ship by measuring a signal from a device provided on a seabed, and transmits a plurality of simulated sensor signals to the dynamic positioning controller system, whereby the test system derives the highly reliable test results based on the modeled control signal and the simulated sensor signal.

Statement under Art. 19.1 PCT
This letter is directed to amending the claims of International Application No. PCT/KR2015/003717. The applicant hereby submits an Amendment to the claims within the scope of the specification and the drawings as originally filed and replacement sheets, after filing of the concerned international application.

**1. Difference between the sheets to be replaced and the replacement sheets**

A part of the elements of amended claim 1 is amended to partially add the following content disclosed in the detailed description: "a ship simulator modeling an actual ship by receiving the modeled control signal to perform ship motion analysis; a sensor simulator including a plurality of virtual sensors and measuring the simulated sensor signal when the ship simulator performs the ship motion analysis;".

Amended claim 2 reads as "The test system of claim 1, wherein the data collection unit includes: a data storage module storing data required in testing the dynamic positioning controller system; a report generation module automatically generating the report based on the test results of the dynamic positioning controller system; and a DP change confirmation module requesting the data stored in the data storage module and performing comparative analysis on the test results of the dynamic positioning controller system, whereby the test system derives the highly reliable test results based on the modeled control signal and the simulated sensor signal". A new inventive subject matter is created by incorporating a part of the content associated with the data collection unit, among the technical contents recited in claims 2 to 4 and 6 before amendment. In compliance with this amendment, claims 2 to 4 and 6 before amendment are also amended to delete overlapping portions with amended claim 2.

According to insertion of amended claim, amended claims 3 to 13 are amended to correspond respectively to the subject matters of claims 2 to 12 before amendment, and the respective claims referred to therein are also amended. As a result, amended claim 13 is newly created.

Also, amendments to rectify the lack of clarity portions as pointed out are also corrected.

**2. Conclusion**

The claims are replaced by the applicant with amended claims as described above to the extent that they do not exceed the scope of the international application as originally filed. Accordingly, the applicant respectfully requests that the international application be amended under Article 19 PCT as described above.
